Europäisches Patentamt

European Patent Office

Office européen des brevets

(11) Veröffentlichungsnummer: **0 359 994**

**A1**

# EUROPÄISCHE PATENTANMELDUNG

(21) Anmeldenummer: **89115088.0**

(22) Anmeldetag: **16.08.89**

(51) Int. Cl.5: **H01L 29/74 , H01L 29/10 , H01L 29/36**

(30) Priorität: **22.09.88 DE 3832208**

(43) Veröffentlichungstag der Anmeldung:
**28.03.90 Patentblatt 90/13**

(84) Benannte Vertragsstaaten:
**AT BE CH DE FR GB IT LI NL**

(71) Anmelder: **ASEA BROWN BOVERI AG**
**Haselstrasse**
**CH-5401 Baden(CH)**

(72) Erfinder: **Bauer, Friedhelm, Dr.**
**Breitenstrasse 9**
**CH-5303 Würenlingen(CH)**
Erfinder: **Grüning, Horst, Dr.**
**Im Ergel 10**
**CH-5404 Baden(CH)**

(54) **Steuerbares Leistungshalbleiterbauelement.**

(57) Bei einem steuerbaren Leistungshalbleiterbauelement mit pnpn-Schichtenfolge aus p-Emitterschicht (9), n-Basisschicht (8), p-Basisschicht (7) und n-Emitterschicht (5) wird durch eine zwischen der n-Basisschicht (8) und der p-Basisschicht (7) eingefügte Zwischenschicht (11), die höher n-dotiert ist als die n-Basisschicht (8), die kritische Feldüberhöhung beim Abschalten reduziert.

FIG.1

EP 0 359 994 A1

### Steuerbares Leistungshalbleiterbauelement

Technisches Gebiet

Die vorliegende Erfindung bezieht sich auf das Gebiet der Leistungselektronik. Sie betrifft insbesondere ein steuerbares Leistungshalbleiterbauelement, umfassend

(a) eine Anode, eine Kathode und ein Gate;

(b) zwischen der Anode und der Kathode eine Schichtenfolge aus einer p-Emitterschicht, einer n-Basisschicht, einer p-Basisschicht und einer n-Emitterschicht; und

(c) auf der Seite der Kathode eine Gate-Kathoden-Struktur.

Ein solches Bauelement ist als MOS-kontrollierter Thyristor (MCT) z.B. aus dem Artikel von V.A.K.Temple, IEEE Transactions on Electron Devides, Vol. ED-33, No.10 (1986), S.1609-1618, oder als Gate-Turn-Off-Thyristor (GTO) z.B. aus der EP-A2 0241662 bekannt.

Stand der Technik

Die moderne Leistungselektronik fordert heute schnelle, mit einfachen Mitteln steuerbare Halbleiterbauelemente bis zu den höchsten Leistungsbereichen. Für kleine und mittlere Leistungen haben sich hierfür bisher insbesondere Leistungs-MOSFETs wegen ihrer grossen Eingangsimpedanz an der Steuerelektrode angeboten.

Höhere schaltbare Leistungen sind aber bekanntermassen nur mit Bipolarstrukturen (Power-BJT, Thyristoren) erreichbar. Dennoch würde man gerne an der einfachen und insbesondere leistungsarmen Steuerung, welche man bei den Leistungs-MOSFETs verwendet, festhalten.

Man hat die positiven Aspekte der Bipolar- und MOS-Strukturen erstmals in Form des IGBT (Insulated Gate Bipolar Transistor) miteinander vereint. Resultat dieser Vereinigung waren wie erwartet Bauelemente der 1kV-Klasse mit wesentlich kleineren Durchlasswiderständen als bei den vergleichbaren Leistungs-MOSFETs.

Andererseits macht sich bei den IGBTs die allen bipolaren Bauelementen inhärente Ueberflutung eines hochohmigen Bereichs des Bauelements bemerkbar: Sie ereichen notgedrungen nicht die hohen Schaltgeschwindigkeiten der entsprechenden unipolaren Bauelemente.

Steuerbare Halbleiterbauelemente für höchste Leistungen sind heute die GTO(Gate Turn Off)-Thyristoren. Im Prinzip unterteilt man auch hier die gesamte Chipfläche in eine Vielzahl von parallel geschalteten Elementarzellen. Ueber den Gatekontakt können diese Bauelemente ein- und ausgeschaltet werden; allerdings ist dabei ein enormer Schaltungsaufwand für die Gateansteuerung in Kauf zu nehmen.

Abhilfe verspricht hier wiederum die MOS-Technologie: es lassen sich verschiedene Strukturen für solche MCTs (MOS Controlled Thyristors) angeben, die alle kathodenseitige, über MOS-Gates schaltbare Kurzschlüsse besitzen.

Es wurde bereits experimentell demonstriert, dass dieses Prinzip es gestattet, Stromdichten von mehr als 1000 Acm$^{-2}$ abzuschalten. Auch bei diesen MCTs ähnelt die Struktur der Kathode denen von Leistungs-MOSFETs und IGBTs. Somit besitzen auch die Elementarzellen vergleichbare Abmessungen (typische Werte lie gen bei 20 - 30 µm). Will man ein grosses Bauelement (z.B. auf einem 4"-Wafer) realisieren, ergeben sich schnell Probleme mit der Fertigungs-Ausbeute. Dennoch zählt der MCT gegenwärtig zu den interessantesten Kandidaten für zukünftige Leistungshalbleiterbauelemente.

Es ist heute üblich, die den Thyristoren eigenen Instabilitäten während des dynamischen Betriebs durch externe Beschaltung mit passiven Bauelementen zu eliminieren. Diese Beschaltung begrenzt die Anstiegsgeschwindigkeit der Anodenspannung (dV/dt) auf die für sicheres Abschalten einzuhaltenden Werte.

Bei Thyristoren vom Typ des GTO können extrem inhomogene Stromdichteverteilungen (Filamente) während des Abschaltens auftreten. Der Strom konzentriert sich dann im wesentlichen auf ein Kathodenelement und kann schnell zur Zerstörung des Thyristors durch thermische Ueberlastung führen. Diesem Effekt muss deshalb durch ein besonderes Design des Bauelements sowie geeignete Schutzschaltungen Rechnung getragen werden.

Allgemein müssen in einem physikalischen System zwei Voraussetzungen erfüllt werden, um eine Ausbildung von Filamenten zu ermöglichen: Zum einen muss das System eine positive Rückkopplung aufweisen. Bei Thyristoren ist dies automatisch durch die pnpn-Struktur gewährleistet. Die zweite Voraussetzung ist die Existenz von Fluktuationen einer oder mehrerer physikalischer Grössen.

Bekannt und bereits beschrieben ist in diesem Zusammenhang z.B. die Stromkonzentration unter den vergleichsweise breiten Steuersegmenten im herkömmlichen GTO. Sie wird durch den begrenzten Querleitwert der p-Basis hervorgerufen; dieser Auslösemechanismus tritt in feinstrukturierten Elementen wie dem MCT nicht auf.

Hieraus darf allerdings nicht die Schlussfolgerung gezogen werden, dass der MCT filamentfrei abschalten könnte. Nach dem heutigen Wissensstand glaubt man, dass beim MCT das Phänomen des "dynamic avalanche" Auslöser für die Filamentierung während des Abschaltens ist (siehe z.B.: M.Stoisiek et al., IEEE International Electron Devices Meeting Techn.Dig.(1987), S.666-669).

Während des Abschaltens durchläuft ein feinstrukturiertes Bauelement wie der MCT Zeitabschnitte, in denen bei sich bereits aufbauender Raumladungszone am PN-Uebergang von der p-Basisschicht zur n-Basisschicht noch erhebliche Ströme fliessen. Wegen des rasch anwachsenden elektrischen Feldes driften jetzt Löcher aus der noch überschwemmten n-Basis mit Driftsättigungsgeschwindigkeit durch die Raumladungszone zur Kathode.

Die Dichte dieser Löcher, welche nur vom externen Strom abhängt, beeinflusst sehr stark den Feldverlauf über der Raumladungszone. Wegen ihrer positiven Ladung bewirken die Löcher eine effektive Erhöhung der Dotierung der n-Basisschicht, welche sich in einer Felderhöhung am PN-Uebergang von der p-Basisschicht zur n-Basisschicht äussert. Je nach Höhe des externen Stromes kann dieser Betrag so gross werden, dass die unter statischen Bedingungen gültige Durchbruchfeldstärke überschritten wird. Mit "dynamic avalanche" ist eben diese Felderhöhung durch freie Löcher sowie der verfrühte Durchbruch gemeint.

Die durch driftende Löcher erzeugte Felderhöhung kann nur in den Fällen ins Gewicht fallen, in denen die n-Basis-Substratdotierung etwa gleich gross oder sogar kleiner ist als die Löcherkonzentration. So wird unter den Bedingungen der Driftsättigung eine Stromdichte von etwa 100 $Acm^{-2}$ durch eine Löcherdichte von $6 \cdot 10^{13}$ $cm^{-3}$ getragen. Dieser Wert liegt in der Tat nahe an den für Thyristoren typischen Substrat dotierungen von $1 \cdot 10^{13}$ $cm^{-3}$ bis $1 \cdot 10^{14}$ $cm^{-3}$ und führt zwangsläufig zu einer starken Felderhöhung beim Abschalten.

Darstellung der Erfindung

Aufgabe der vorliegenden Erfindung ist es nun, ein steuerbares Leistungshalbleiterbauelement zu schaffen, bei dem diese Felderhöhung erheblich reduziert ist.

Die Aufgabe wird bei einem Bauelement der eingangs genannten Art dadurch gelöst, dass

(d) zwischen der n-Basisschicht und der p-Basisschicht eine n-dotierte Zwischenschicht angeordnet ist; und

(e) die Dotierungskonzentration in der Zwischenschicht höher ist als in der n-Basisschicht.

Gemäss einem ersten bevorzugten Ausführungsbeispiel der Erfindung weist das Bauelement die Struktur eines MOS-kontrollierten Thyristors (MCT) auf.

Ein zweites bevorzugtes Ausführungsbeispiel ist dadurch gekennzeichnet, dass die Dotierungskonzentration in der n-Basisschicht ungefähr zwischen $1 \cdot 10^{13}$ $cm^{-3}$ und $1 \cdot 10^{14}$ $cm^{-3}$ und in der Zwischenschicht ungefähr zwischen $2 \cdot 10^{14}$ $cm^{-3}$ und $8 \cdot 10^{14}$ $cm^{-3}$ liegt.

Gemäss einem weiteren bevorzugten Ausführungsbeispiel weist die Zwischenschicht eine Dicke zwischen 10 $\mu m$ und 20 $\mu m$ auf.

Weitere Ausführungsbeispiele ergeben sich aus den Unteransprüchen.

Kurze Beschreibung der Zeichnung

Die Erfindung soll nachfolgend anhand von Ausführungsbeispielen im Zusammenhang mit der Zeichnung näher erläutert werden. Es zeigen

Fig.1 im Ausschnitt den Querschnitt durch die Einheitszelle eines MCT mit der erfindungsgemässen Zwischenschicht;

Fig.2 ein beispielhaftes Dotierungsprofil c(x) für einen MCT nach der Erfindung; und

Fig.3A,B die auf verschiedenen Wegen errechnete Abhängigkeit des Feldüberhöhungsfaktors m von der Junction-Spannung $V_J$.

Wege zur Ausführung der Erfindung

Die Erfindung wird im Folgenden am Beispiel des MCT erläutert, kann jedoch in gleicher Weise auch beim herkömmlichen Thyristor angewendet werden.

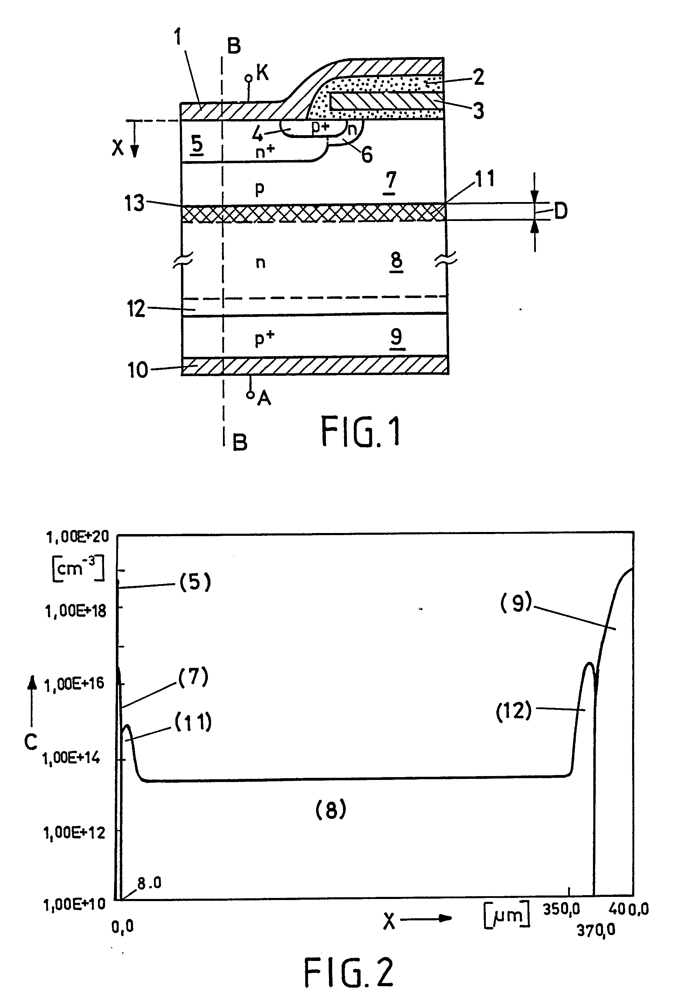

Fig.1 zeigt zunächst ausschnittweise die typische Einheitszelle eines MCT im Querschnitt. Zwischen einer Anode A und einer Kathode K mit einem entsprechenden Anodenkontakt 10 und Kathodenkontakt 1 ist eine Schichtenfolge aus einer $p^+$-dotierten p-Emitterschicht 9, einer n-dotierten n-Basisschicht 8, einer p-dotierten p-Basisschicht 7 und einer $n^+$-dotierten n-Emitterschicht 5 angeordnet. Die n-Basisschicht 8 und die p-Basisschicht 7 bilden einen PN-Uebergang 13.

Die p-Basisschicht 7 tritt in einem bestimmten Bereich an die Oberfläche des Halbleitersubstrats und bildet dort zusammen mit einem n-dotierten Kanalgebiet 6, einem $p^+$-dotierten Sourcegebiet 4 und einer darüberliegenden, durch eine Gateisolierung 2 vom Substrat getrennten Gateelektrode 3 einen MOS-kontrollierten Kurzschluss. Die Wirkungsweise dieser Anordnung kann im Einzelnen dem o.g. Artikel von V.A..Temple entnommen werden.

Gemäss der Erfindung wird diese an sich bekannte Thyristorstruktur nun kathodenseitig zwischen der n-Basisschicht 8 und der p-Basisschicht 7 um eine Zwischenschicht 11 erweitert, welche eine höhere n-Dotierung aufweist als die n-Basisschicht 8.

Die Maximalwerte der Dotierungskonzentration in der Zwischenschicht 11 liegen dabei vorzugsweise ungefähr im Bereich von $2 \cdot 10^{14}$ cm$^{-3}$ bis $8 \cdot 10^{14}$ cm$^{-3}$.

Weiterhin hat die Zwischenschicht vorzugsweise eine Dicke D im Bereich zwischen 10 und 20 μm.

Vorteilhaft ist darüberhinaus die Einfügung einer höher n-dotierten Bufferschicht 12 zwischen der n-Basisschicht 8 und der p-Emitterschicht 9.

Fig.2 zeigt im logarithmischen Massstab eine typische Verteilung der Dotierungskonzentration c entlang der in Fig.1 eingezeichneten Schnittlinie B - B in Abhängigkeit von der dort definierten Tiefe x. Die Substratdotierung bzw. die Dotierung den n-Basisschicht 8 beträgt hierbei $2 \cdot 10^{13}$ cm$^{-3}$.

Die Feldüberhöhung beim schnellen Abschalten wird durch die erfindungsgemässe Zwischenschicht 11 drastisch reduziert. Um dies näher erläutern zu können, soll an dieser Stelle zunächst ein Mass ähnlich einer "figure of merit" definiert werden, welches es gestattet, die vorgeschlagenen Strukturen bezüglich der Feldüberhöhung zu bewerten.

Zu diesem Zweck wird ein Quotient gebildet, der als Feldüberhöhungsfaktor m bezeichnet werden soll. Diese dimensionslose Zahl ist das Verhältnis der maximalen elektrischen Feldstärke in Gegenwart driftender Löcher zur maximalen Feldstärke im statischen Fall (kein Stromfluss über den PN-Uebergang).

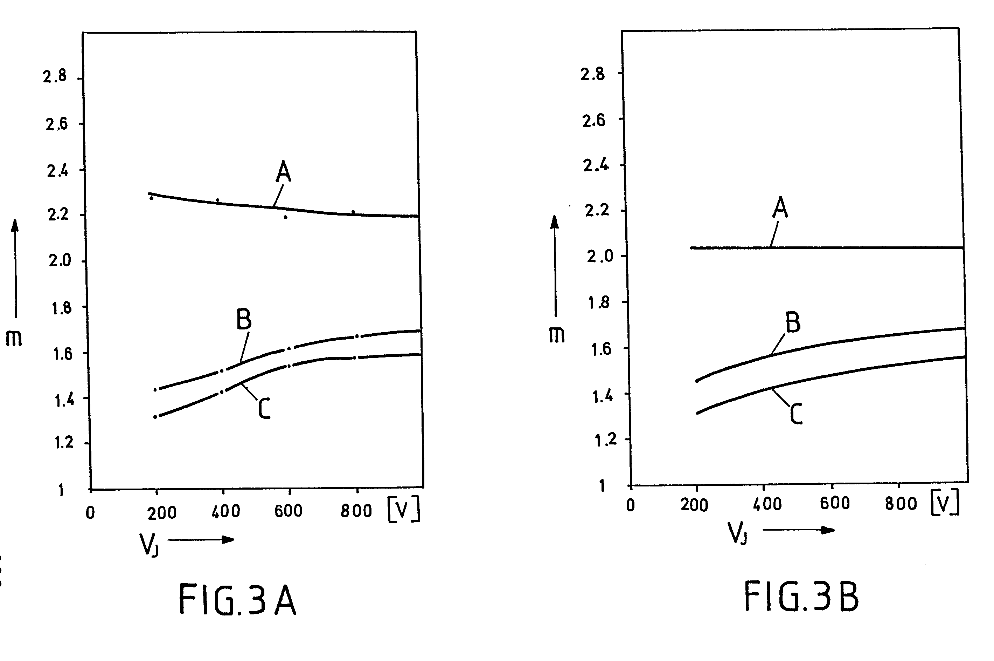

Betrachtet wird nun für eine Struktur mit dem Dotierstoffprofil aus Fig.2 (max.Dotierung der Zwischenschicht 11: $8 \cdot 10^{14}$ cm$^{-3}$) sowie für ein weiteres nicht dargestelltes, aber zu Fig.2 analoges Dotierstoffprofil (max.Dotierung der Zwischenschicht 11: $5 \cdot 10^{14}$ cm$^{-3}$) und schliesslich für eine herkömmliche Struktur ohne Zwischenschicht (konstante Dotierung der n-Basisschicht: $2 \cdot 10^{13}$ cm$^{-3}$) der oben definierte Felderhöhungsfaktor m als Funktion der Junction-Spannung $V_J$ über dem PN-Uebergang 13 (Fig.3A,B).

Die in Fig.3A dargestellten Kurven A, B und C (eine Löcherstromdichte von 100 Acm$^{-2}$ wurde hier angenommen) wurden aus Simulationen mit dem eindimensionalen Device-Simulationsprogramm COMPASS gewonnen. Für die herkömmliche Struktur (Kurve A) erhält man einen Wert von etwa 2,2 für den Feldüberhöhungsfaktor m, welcher in erster Näherung unabhängig von der anliegenden Junction-Spannung ist. Die relative Erhöhung des elektrischen Feldes beträgt also 120%.

Durch die Einführung der erfindungsgemässen Zwischenschicht 11 (Kurven B und C; max.Dotierung bei Kurve B: $5 \cdot 10^{14}$ cm$^{-3}$;

max.Dotierung bei Kurve C: $8 \cdot 10^{14}$ cm$^{-3}$) kann der Feldüberhöhungsfaktor m bis auf Werte von 1,3 (V = 200V) bis 1,5 (V = 1000V) begrenzt werden. Fig.3 zeigt für die gleichen Strukturen vergleichbare Kurven, welche aus einer analytischen Betrachtung gewonnen worden sind.

Naturgemäss führt die Einfügung der Zwischenschicht 11 zu einer Reduzierung der statischen Durchbruchspannung des PN-Uebergangs 13. Die Verringerung der Durchbruchspannung ist bei geschickter Auslegung der Dotierung und Dicke der Zwischen schicht (wie in den obigen Beispielen bereits geschehen) aber durchaus tolerierbar.

Aus Rechnungen mit Hilfe des bereits erwähnten numerischen Simulationsprogramms COMPASS hat sich ergeben, dass die erreichbare Durchbruchspannung durch das Einfügen der höher dotierten Zwischenschicht kleiner ist als die ideale Durchbruchspannung des Thyristors mit homogen dotierter n-Basis. Für eine Dotierung in der n-Basisschicht von $1 \cdot 10^{14}$ cm$^{-3}$ und eine Dicke D der Zwischenschicht von 15 μm ergeben sich für verschieden maximale Dotierungen der Zwischenschicht z.B. folgende Durchbruchspannungen (in % der Durchbruchspannung ohne Zwischenschicht):
$3 \cdot 10^{14}$ cm$^{-3}$: 91,8 %
$5 \cdot 10^{14}$ cm$^{-3}$: 83,9 %
$8 \cdot 10^{14}$ cm$^{-3}$: 71,1 %

Bei einer Dotierung in der n-Basisschicht von $2 \cdot 10^{14}$ cm$^{-3}$ lauten die analogen Ergebnisse:
$3 \cdot 10^{14}$ cm$^{-3}$: 97,4 %
$5 \cdot 10^{14}$ cm$^{-3}$: 91,1 %
$8 \cdot 10^{14}$ cm$^{-3}$: 82,3 %

Akzeptiert man eine Reduktion um 20%, so können bei der hier zugrundegelegten Dicke der Zwischenschicht von 15 μm maximale Dotierungen von $5 \cdot 10^{14}$ bis $8 \cdot 10^{14}$ cm$^{-3}$ realisiert werden. Abschliessend soll noch darauf hingewiesen werden, dass natürlich bereits durch den Randabschluss des Bauelements eine Reduktion der idealen Durchbruchspannung um typischerweise 10 bis 30% unvermeidbar ist, sodass die Verringerung infolge der erhöhten Dotierung der n-Basis kaum noch ins Gewicht fällt.

Die Erfindung zielt darauf ab, in erster Linie bei MCTs den verfrühten dynamischen Durchbruch aufgrund einer Filamentierung zu verhindern. Wegen der im Vergleich zu herkömmlichen Thyristoren sehr dünnen p-Basisschicht dieser Bauelemente kann die vorgeschlagene Zwischenschicht gerade hier besonders einfach durch einen Implantations- oder Diffusionsschritt (Phosphor) mit anschliessender Temperung erzeugt werden.

Dieser Schritt liegt vor der Durchführung der einzelnen Dotierungen zur Herstellung von p-Basisschicht, n-Emitterschicht und Sourcegebiet. Für die Erzeugung der Zwischenschicht in Thyristoren mit dickerer p-Basisschicht scheidet die einfache Diffusionstechnik aus. Epitaktisches Wachstum dotierter Schichten ist ein weiteres alternatives Verfahren für die Herstellung der angestrebten Schichten. Mit Hilfe der Epitaxie kann das Prinzip der Erfindung auch bei herkömmlichen Thyristoren angewandt werden.

## Ansprüche

1. Steuerbares Leistungshalbleiterbauelement, umfassend
(a) eine Anode (A), eine Kathode (K) und ein Gate;
(b) zwischen der Anode (A) und der Kathode (K) eine Schichtenfolge aus einer p-Emitterschicht (9), einer n-Basisschicht (8), einer p-Basisschicht (7) und einer n-Emitterschicht (5); und
(c) auf der Seite der Kathode (K) eine Gate-Kathoden-Struktur;
dadurch gekennzeichnet, dass
(d) zwischen der n-Basisschicht (8) und der p-Basisschicht (7) eine n-dotierte Zwischenschicht (11) angeordnet ist; und
(e) die Dotierungskonzentration (c) in der Zwischenschicht (11) höher ist als in der n-Basisschicht (8).

2. Abschaltbares Leistungshalbleiterbauelement nach Anspruch 1, dadurch gekennzeichnet, dass das Bauelement die Struktur eines MOS-kontrollierten Thyristors (MCT) aufweist.

3. Abschaltbares Leistungshalbleiterbauelement nach Anspruch 1, dadurch gekennzeichnet, dass die Dotierungskonzentration (c) in der n-Basisschicht (8) ungefähr zwischen $1^*10^{14}$ $cm^{-3}$ und $1^*10^{14}$ $cm^{-3}$ und in der Zwischenschicht (11) ungefähr zwischen $2^*10^{14}$ $cm^{-3}$ und $8^*10^{14}$ $cm^{-3}$ liegt.

4. Abschaltbares Leistungshalbleiterbauelement nach Anspruch 3, dadurch gekennzeichnet, dass die Zwischenschicht (11) eine Dicke (D) zwischen 10 µm und 20 µm aufweist.

5. Abschaltbares Leistungshalbleiterbauelement nach Anspruch 4, dadurch gekennzeichnet, das zwischen der n-Basisschicht (8) und der p-Emitterschicht (9) eine gegenüber der n-Basisschicht (8) höher n-dotierte Bufferschicht (12) angeordnet ist.

FIG.1

FIG.2

8 8/096

FIG.3B

FIG.3A

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | I.E.E.E. TRANSACTIONS ON ELECTRON DEVICES, Band ED-33, Nr. 10, Oktober 1986, Seiten 1609-1618, IEEE, New York, NY, US; V.A.K. TEMPLE: "MOS-controlled thyristors-A new class of power devices"<br>* Figuren 3,8,10 *<br>--- | 1-3,5 | H 01 L 29/74<br>H 01 L 29/10<br>H 01 L 29/36 |
| A | GB-A-1 096 777 (ALLMÄNNA SVENSKA ELEKTRISKA AB)<br>* Seite 2, Zeilen 48-63,90-129; Figuren 2,5 *<br>--- | 1,5 | |
| A | EP-A-0 164 867 (GENERAL MOTORS CORP.)<br>* Figuren 2,4 *<br>----- | 1,2 | |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| DEN HAAG | 14-12-1989 | MORVAN D.L.D. |

EPO FORM 1503 03.82 (P0403)